# EUROPÄISCHE PATENTSCHRIFT

(11) **EP 0 975 821 B1**
(45) Veröffentlichungstag und Bekanntmachung des Hinweises auf die Patenterteilung: **17.10.2001**
(21) Anmeldenummer: 99910144.7
(22) Anmeldetag: 18.02.1999
(51) Int. Cl.: C23C 16/44

(54) **CVD-REAKTOR UND DESSEN VERWENDUNG**
CVD REACTOR AND USE THEREOF
REACTEUR DE DEPOT CHIMIQUE EN PHASE VAPEUR ET SON UTILISATION

(30) Priorität: 18.02.1998 DE 19806776; 26.03.1998 DE 19813523
(43) Veröffentlichungstag der Anmeldung: 02.02.2000
(73) Patentinhaber: AIXTRON Aktiengesellschaft, 52072 Aachen (DE)
(72) Erfinder: JÜRGENSEN, Holger, D-52072 Aachen (DE); DESCHLER, Marc, D-52074 Aachen (DE); STRAUCH, Gerd, D-52072 Aachen (DE); SCHUMACHER, Markus, D-52428 Jülich (DE); KÄPPELER, Johannes, D-52146 Würselen (DE)
(74) Vertreter: Münich, Wilhelm, Dr.
(86) Internationale Anmeldenummer: DE9900455
(87) Internationale Veröffentlichungsnummer: WO9942636

(56) Entgegenhaltungen:
- US-A- 3 854 443
- US-A- 5 593 540
- US-A- 5 670 218
- PATENT ABSTRACTS OF JAPAN vol. 096, no. 003, 29. März 1996 & JP 07 302765 A (NIPPON ASM KK), 14. November 1995
- PATENT ABSTRACTS OF JAPAN vol. 096, no. 012, 26. Dezember 1996 & JP 08 218171 A (NIPPON SANSO KK), 27. August 1996

## Beschreibung

### Technisches Gebiet

Die Erfindung bezieht sich auf einen CVD-Reaktor gemäß dem Oberbegriff des Patentanspruchs 1, sowie dessen Verwendung.

### Stand der Technik

CVD-Reaktoren sind allgemein bekannt und werden beispielsweise von der Aixtron AG, Aachen, DE hergestellt und vertrieben. Auf diese bekannten CVD-Reaktoren wird zur in Erläuterung aller hier nicht näher beschriebenen Begriffe ausdrücklich verwiesen.

Die bekannten CVD-Reaktoren weisen ein Reaktorgehäuse mit einem Deckel auf, in dem ein geheizter Susceptor (Waferträger) vorgesehen ist, auf dem wenigstens ein Wafer angeordnet werden kann. Als Einlaß für CVD-Gase oder Flüssigkeiten ist in der Regel ein zentraler Fluideinlaß vorgesehen. Der Fluidauslaß ist dann meistens am Umfang des Reaktorgehäuses angeordnet.

Als Fluideinlaß werden entweder zentrale Gaseinlaßdüsen (Gasinlet-Nozzles), die die Gase vom Zentrum des Reaktors radial über die Wafer ausströmen lassen, oder sog. Brauseköpfe (Showerheads) im bzw. am Reaktordeckel verwendet, die direkt oberhalb des Wafers angeordnet sind, und aus sehr vielen kleinen Löchern das Gas in Form einer Dusche vertikal nach unten auf die Wafer sprühen. Derartige Reaktoren werden beispielsweise von der Fa. Thomas Swan, GB vertrieben.

Einen ähnlichen Aufbau offenbart die DE 43 30 266 gemäß der eine Einzel-Wafer- Reaktionskammer eine Wafer-Erwärmerstufe zum Halten eines Wafers nach unten und zum Erwärmen des Wafers aufweist. Weiter befindet sich gegenüber der Wafer-Erwärmstufe ein Gaseinlaßdüsen aufweisender Gasversorgungskopf, wodurch ein Bereich mit konstantem Abstand zum Zuleiten von Reaktionsgas entsteht. Über den Gasversorgungskopf werden Gase über dem Wafer ausgeströmt. Ein Abgasauslaß existiert ebenfalls.

Nun gibt es Materialien, für die es von Vorteil ist, wenn die Gase temperiert in den Reaktor eingelassen werden. Dies kann man dadurch erreichen, daß die Gase vorgewärmt werden, oder daß der Einlaß geheizt wird.

Für als Brausekopf (Showerhead) ausgebildete Fluideinlässe ist es bekannt, den Brausekopf (Showerhead) mit komplizierten Wasserkanälen zur Thermostatisierung auszurüsten. Diese Ausgestaltung hat nicht nur den Nachteil, daß sie aufwendig und damit teuer ist, sondern auch den Nachteil, daß der Einsatz von Wasserkanälen in CVD-Reaktoren immer ein gewisses Risiko darstellt. Beispielsweise kann im Falle eines Lecks das Kühlwasser in den Reaktor-Innenraum austreten und mit dem oder den CVD-Gasen explosionsartig reagieren. Ein weiterer Nachteil ist die mit der Wassererwärmung einhergehende Temperaturinhomogenität im Brausekopf (Showerhead).

Gemäß der DE 43 30 266 wird das Gas über einen Gasversorgungskopf und dessen Gaseinlaßdüsen in dem Bereich mit konstantem Abstand über einen Wafer geleitet. Auch hier wird im Einlaßbereich die Temperatur der Gase durch einen Kühlwasserpfad und ein Wärmeerhaltungselement beeinflußt. Dabei wird die Temperatur der Innenwand eines Raumelements, welches an die Gaseinlaßbereiche angrenzt, auf einer konstanten Temperatur gehalten. Hier gelten ebenso die vorstehend angeführten Nachteile für Wasserkanäle.

### Darstellung der Erfindung

Der Erfindung liegt die Aufgabe zugrunde, einen CVD-Reaktor mit einem als Brausekopf (Showerhead) oder Gaseinlaßdüsen ausgebildeten Fluideinlaß derart weiterzubilden, daß der Fluideinlaß und damit die einzulassenden Fluide, also Gase und/oder Flüssigkeiten in einfacher Weise und insbesondere unter Verzicht auf Wasserkanäle etc. temperiert werden können.

Eine erfindungsgemäße Lösung dieser Aufgabe ist im Patentanspruch 1 angegeben. Weiterbildungen der Erfindung sind Gegenstand der Ansprüche 2 folgende. In den Ansprüchen 31 und 32 sind Verfahren unter Verwendung eines erfindungsgemäß angegebenen Reaktors beansprucht.

Erfindungsgemäß wird ein CVD-Reaktor mit den im Oberbegriff des Patentanspruchs 1 aufgeführten Merkmalen derart weitergebildet,
- daß die Fluideinlaßeinheit einen vom Reaktordeckel beabstandeten Hohlkörper aufweist, dessen Unterseite, in der die Öffnungen vorgesehen sind, im wesentlichen durch Wärmestrahlung vom Susceptor (Waferträger) erwärmt wird,
- daß eine Spülgaseinlaßvorrichtung vorgesehen ist, die in den Zwischenraum zwischen der Oberseite des Hohlkörpers und dem Reaktordeckel ein Spülgas derart einleitet, daß die Oberseite Wärme im wesentlichen durch Wärmeleitung in dem Gas an die Umgebung abgibt, und
- daß die Wärmezu- und ableit-Bedingungen zum bzw. vom Hohlkörper derart eingestellt sind, daß sich die Unterseite ohne Zufuhr eines Temperiermediums von außen auf eine wählbare Temperatur, durch die die CVD-Medien temperiert werden, einstellt, und daß zwischen der Oberseite und der Unterseite des Hohlkörpers ein positiver Temperaturgradient besteht.

Unter CVD-Medien werden im Rahmen der vorliegenden Beschreibung CVD- und insbesondere MOCVD-Gase, Flüssigkeiten, Lösungen oder Gemische der vorstehenden Stoffe - im folgenden auch allgemein mit dem Oberbegriff "Fluid" bezeichnet - verstanden.

Erfindungsgemäß wird ein bekannter CVD-Reaktor also dadurch weitergebildet, daß die Fiuideinlaßeinheit eine Einheit aufweist, die in etwa die Form einer Hohlscheibe mit einer Vielzahl von Auslaßöffnungen für die CVD-Medien etc. - also eines an sich bekannten Brausekopfs (Showerhead) - hat, und zwischen Susceptor (Waferträger) und Reaktordeckel derart angeordnet ist, daß die Unterseite der Fluideinlaßeinheit durch Strahlung vom Susceptor (Waferträger) beheizt wird, und sich damit auf eine Temperatur zwischen der Temperatur des Susceptors (Waferträgers) und dem Reaktordeckel einstellt, so daß die CVD-Medien etc. beim Passieren der Fluideinlaßeinheit temperiert werden. Da an der Oberseite der Fluideinlaßeinheit eine (einstellbare) Wärmesenke vorgesehen ist, stellt sich in Axialrichtung über die Fluideinlaßeinheit ein bestimmter Temperaturgradient ein.

Die Erfindung geht dabei von dem Grundgedanken aus, den komplizierten Aufbau bekannter Reaktoren, bei denen die Thermostatisierung des Reaktordeckels und des Gaseinlasses in Form eines mit Flüssigkeit durchströmten Brausekopfs (Showerhead) und dafür erforderlicher separter Heizaggregate erfolgt, dadurch zu vereinfachen, daß man den Brausekopf (Showerhead) vom Reaktordeckel getrennt als separates Bauteil ausführt. Da der Susceptor (Waferträger) ohnehin durch eine Infrarot-Heizung, eine Widerstandsheizung oder eine Hochfrequenzheizung auf eine Temperatur zwischen typischerweise ca. RT°C und 1200°C (RT steht für Raumtemperatur) aufgeheizt wird, und somit eine beträchtliche Wärmemenge über Strahlung an seine Umgebung abgibt, wird die Fluideinlaßeinheit aufgeheizt. Durch die erfindungsgemäßen Maßnahmen wird die Temperatur, auf die die Fluideinlaßeinheit aufgeheizt wird, kontrolliert eingestellt.

Bevorzugt bringt man einen aus einem gut wärmeleitfähigem Metall gefertigten dünnen Brausekopf (Showerhead) in dem Reaktor unterhalb des Reaktordeckels sowie gegebenenfalls unterhalb einer thermostatisierten Decke (ceiling) an.

### Dieser Aufbau hat eine Reihe von Vorteilen:

Der Brausekopf (Showerhead) wird direkt durch Strahlung von unten vom Susceptor (Waferträger) beheizt. Insbesondere kann der Abstand zwischen Susceptor (Waferträger) und Hohlkörper zur Einstellung der Temperatur der Unterseite des Hohlkörpers einstellbar sein. Hierzu kann eine Halteeinheit für den Hohlkörper mit einem Gewinde vorgesehen sein.

Die Wärmezu- bzw. abfuhr zum bzw. vom Hohlkörper wird durch die Temperatur des Susceptors (Waferträgers), des nun frei justierbaren Abstands zum Susceptor (Waferträger), und die Leitfähigkeit des Gases im Reaktor (Wahl des Trägergases, beispielsweise Stickstoff oder Wasserstoff oder ein Gemisch dieser Gase und Totaldruck) bestimmt. Eine bisher nötige Beistellung eines zusätzlichen Heizaggregates zur Beheizung und Temperierung des Brausekopfs (Showerhead) entfällt.

Die Wärmeabfuhr nach oben von der Oberseite des Brausekopfs (Showerhead) weg wird dadurch bestimmt, welches Spülgas oberhalb des Brausekopfs (Showerhead) und der Quarz-Decke (quarz ceiling) und welches Spülgas zwischen Quarz-Decke (quarz ceiling) und MetallReaktor-Deckel benutzt wird.

Hierbei kann insbesondere die von Frijlink et al. vorgeschlagene thermostatisierte Decke (ceiling) zur Anwendung kommen. Insofern wird durch die Anwendung von zwei Spülgasgemischen die absolute Temperatur und der Temperatur-Gradient des Brausekopfs (Showerhead) im Reaktor sehr präzise regel- bzw. einstellbar.

Vor allem wird der bei den meisten Anwendungen gewünschte positive Temperatur-Gradient vom Brausekopf (Showerhead) zum Susceptor (Waferträger) automatisch gewährleistet. Der Temperatur-Gradient kann zusätzlich durch eine weitere Ausgestaltung kontrolliert beeinflußt werden, indem lokal Wärmeabschirmbleche und eine Mehrlagen-Ausführung des Brausekopfs (Showerhead) mit Materialien eingeführt werden, die unterschiedliche Reflexions- und Absorptions-Koeffizienten aufweisen.

Ansonsten ist der Reaktor konventionell aufgebaut: Insbesondere kann der Reaktor ein runder Reaktor - ähnlich dem bekannten Planetenreaktor - mit zentralem Gaseinlaß und außen herumliegenden Gasauslaß (Exhaust) sein. Der Gasauslaß (Exhaust) kann insbesondere der von Frijlink et al. vorgeschlagene Tunnel sein. Die Decke des Reaktors kann ebenfalls wie die von Frijlink vorgeschlagene Decke (ceiling) ausgeführt und damit thermostatisierbar sein.

Der Susceptor (Waferträger) ist entweder ein Planetensusceptor (Planetenwaferträger) mit doppelter Rotation oder nur eine große einfache Scheibe, die aber auch auf Gas-Foil-Rotation (d.h. Drehung der Wafer auf einem Gaspolster; Patent der Anmelderin Fa. Aixtron) oder aber mechanisch rotiert. In letzterem Fall kann man dann jeweils nur einen Wafer, aber dafür größere Wafer zentral auflegen. Alternativ oder zusätzlich ist es möglich, die Fluideinlaßvorrichtung um ihre axiale Achse zu drehen.

Für die Schichtherstellung von Mehrkomponenten-Stoffsystemen werden z.B. β-Diketonate oder andere Metall-organischen Lösungen verwandt, deren Mischung nun einerseits direkt im Brausekopf (Showerhead) durchgeführt werden kann, durch konstruktive Einrichtung eines oder mehrerer Einlässe in den Brausekopf (Showerhead), mit gleicher oder unterschiedlicher Temperatur. Andererseits kann der Brausekopf (Showerhead) auch derart ausgebildet sein, daß verschiedene Gase separat im Brausekopf (Showerhead) geführt werden, und eine Durchmischung erst bei Austritt aus dem Brausekopf (Showerhead) in den Reaktorraum erfolgt, um parasitäre Vorreaktionen zu vermeiden.

Das Risiko, zusätzliches Kühlwasser in der Nähe des Gaseinlasses zur Thermostatisierung zu benutzen, entfällt. Der Brausekopf (Showerhead) ist wesentlich einfacher justierbar und austauschbar. Der Reaktor wird sehr flexibel, da die verschiedensten Brauseköpfe (Showerheads) sehr schnell eingesetzt und ausgetauscht werden können, für unterschiedliche Wafergrößen, ohne größere Veränderung des Reaktors, Demontage oder Öffnung von Medienleitungen. Der Reaktor ist thermisch von allen Seiten bestimmt, und alle Wände sind geheizt, so daß minimale Ablagerungen entstehen.

Ein weiterer Vorteil ist, daß jeder vorhandene Planetenreaktor sehr einfach umrüstbar ist, da die Fluideinlaßeinheit voll kompatibel zu herkömmlichen Einlässen ist.

Der erfindungsgemäße Reaktor kann für alle Arten von CVD-Prozessen benutzt werden, also z.B. zum Aufbringen bzw. Bearbeiten von III-V, II-VI, IV-IV Materialien, femer von ein- und mehrkomponentigen Oxiden, Perowskiten, wie z. B. Barium- und Strontium-Titanat (ST bzw. BT), Barium-Strontium-Titanat (BST), Strontium- und Barium-Zirkonat-Titanate, Strontium-Wismut-Tantalat (SBT), Blei-Zirkonat-Titanat (PZT), sowie von mit Akzeptor- oder/und Donator-Dotierungen versehenen oben aufgeführten Materialsystemen.

Ein weiterer Vorteil ist, daß die Brauseköpfe (Showerheads) sehr leicht austauschbar sind. Damit ist es möglich, je nach verwendeter Waferform Brauseköpfe (Showerheads) einzusetzen, deren Loch- bzw. Auslaßanordnung der Anordnung und Form der darunter angeordneten Wafern entspricht, so daß eine sehr homogene und dennoch sparsame Bearbeitung bzw. Beschichtung der Wafer möglich ist.

Darüberhinaus kann der erfindungsgemäß ausgebildete Reaktor auch mit Ätz- bzw. Reinigungsfluiden betrieben werden, um ggf. entstehende Ablagerungen bzw. Kondensate schnellsten wieder zu entfernen (self cleaning). In dieser Bauart wird der Reaktor mit einem Brausekopf (Showerhead) aus einem Material ausgerüstet, das gegenüber dem Ätzgas resistiv ist.

Weiterhin kann der Reaktor mit einem normalen Gasversorgungssystem betrieben werden, oder aber auch mit einem Quellenverteilungssystem (Liquid-Delivery-System) oder Aerosol-System, das die Gase schon temperiert zuführt (sog. LDS-System).

Die Rotationsgeschwindigkeit ist im Falle von doppelter Rotation (Planetenrotation) relativ langsam und liegt typischerweise zwischen 10 und 200 Umdrehungen pro Minute (rpm).

Falls nur ein Wafer zentral eingesetzt wird, können verschiedenste Rotationen zwischen 5 und 1500 Umdrehungen pro Minute (rpm) benutzt werden.

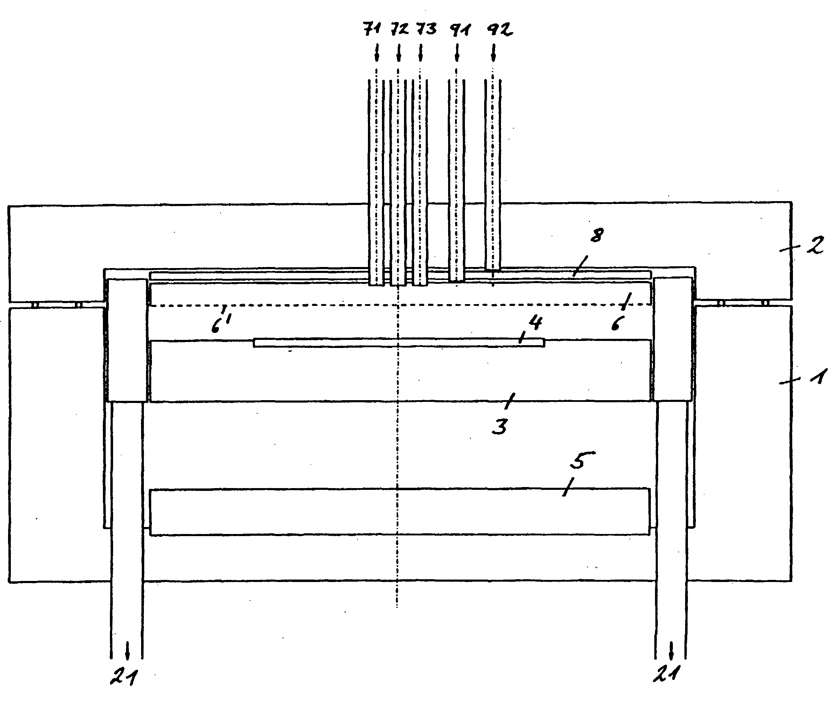

### Kurze Beschreibung der Zeichnung

Die Erfindung wird nachstehend ohne Beschränkung des allgemeinen Erfindungsgedankens anhand eines Ausführungsbeispielen unter Bezugnahme auf die Zeichnung exemplarisch beschrieben, deren
einzige Figur einen schematisierten Querschnitt
durch eine erfindungsgemäße Vorrichtung zeigt.

Der in der Figur im Querschnitt dargestellte CVD-Reaktor weist ein Reaktorgefäß 1 mit einem Reaktordeckel 2 auf. Das Reaktorgefäß 1 und der Deckel 2 sind bei dem gezeigten Ausführungsbeispiel wassergekühlt, so daß sie sich immer in etwa auf Raumtemperatur befinden. Im Reaktorgefäß 1, das insbesondere eine zylindrische Form haben kann, ist ein Gasauslaß 21 in an sich bekannter Weise vorgesehen.

Im Innenraum des Reaktorgefäßes 1 ist ferner ein Susceptor (Waferträger) 3 für Wafer 4 angeordnet, die mittels eines CVD-Prozesses bearbeitet bzw. beschichtet werden sollen. Der Susceptor (Waferträger) 3 wird mittels einer Heizeinrichtung 5, die eine Infrarot-Heizung, eine Widerstandsheizung oder eine Hochfrequenzheizung sein kann, auf eine Temperatur zwischen ca. RT°C und 1200 °C (RT steht für Raumtemperatur) aufgeheizt.

Oberhalb des Susceptors (Waferträgers) 3 ist eine Fluideinlaßeinheit 6 angeordnet, die bei dem gezeigten Ausführungsbeispiel die Form einer Hohlscheibe hat. In der Unterseite 6' der Einheit 6 sind eine Vielzahl von Löchern (in der Figur schematisch dargestellt) vor gesehen, deren Anordnung der Form der Wafer 4 angepaßt sein kann. Der Abstand zwischen Fluideinlaßeinheit 6 und Susceptor (Waferträger) 3 ist beispielsweise über ein Gewinde einstellbar.

In den Innenraum der Hohlscheibe 6 münden Leitungen 71 bis 73, durch die Gase und insbesondere CVD-Gase von einer nicht dargestellten, im übrigen jedoch bekannten Gasversorgungseinheit - die gegebenenfalls eine Vortemperiereinrichtung aufweist - in den Innenraum der Hohlscheibe 6 strömen. Die Gase treten dann aus dem Innenraum durch die (nicht dargestellten) Löcher aus und beaufschlagen homogen die Wafer 4.

Zwischen der Hohlscheibe 6 und der Unterseite des Reaktordeckels 2 ist ein Wärmeschild 8, auch als Decke (ceiling) bezeichnet, vorgesehen. Der Wärmeschild 8 ist eine Platte aus einem wärmeresistenten und inerten Material, bei dem gezeigten Ausführungsbeispiels besteht die Platte aus Quarz.

Ferner ist eine Spülgaseinlaßvorrichtung vorgesehen, die über Leitungen 91 und 92 mit dem Reaktor verbunden ist. Die Leitung 91 mündet in dem Zwischenraum zwischen Wärmeschild 8 und Oberseite der Hohlscheibe 6, die Leitung 92 mündet in dem Zwischenraum zwischen Reaktordeckel 2 und Wärmeschild 8. Die Spülgaseinlaßvorrichtung ist derart ausgebildet, daß die Zusammensetzung und/oder der Durchsatz des bzw. der in den bzw. die Zwischenräume oberhalb der Oberseite des Hohlkörpers eingeleiteten Gase zur Einstellung der Wärmeableitbedingungen änderbar ist.

Die Wärmezu- und ableit-Bedingungen zum bzw. vom Hohlkörper 6 können derart eingestellt, daß sich die Unterseite ohne Zufuhr eines Temperiermediums von außen auf eine wählbare Temperatur, durch die die CVD-Medien temperiert werden, einstellt, und daß zwischen der Oberseite und der Unterseite des Hohlkörpers ein positiver Temperaturgradient besteht. Hierdurch wird ein Zusetzen der Löcher vermieden Darüberhinaus besteht ein positiver Temperaturgradient zum Susceptor (Waferträger).

## Patentansprüche

1. CVD-Reaktor mit
- einem Reaktorgehäuse mit einem Gehäusedeckel,
- einem in dem Reaktorgehäuse angeordneten geheizten Susceptor (Waferträger) für ein oder mehrere Wafer,
- einer Fluideinlaßeinheit mit einer Vielzahl von dem oder den Wafern zugewandten Öffnungen, durch die insbesondere temperierte CVD-Medien etc. in den Reaktor eintreten, und
- einem Fluidauslaß, der am Umfang des Reaktorgehäuses angeordnet ist, und durch den die eingelassenen Medien wieder austreten,
**dadurch gekennzeichnet,**
- daß die Fluideinlaßeinheit einen vom Reaktordeckel beabstandeten Hohlkörper aufweist, dessen Unterseite, in der die Öffnungen vorgesehen sind, im wesentlichen durch Wärmestrahlung und/oder durch Wärmeleitung vom Susceptor (Waferträger) erwärmt wird,
- daß eine Spülgaseinlaßvorrichtung vorgesehen ist, die in den Zwischenraum zwischen der Oberseite des Hohlkörpers und dem Reaktordeckel ein Spülgas derart einleitet, daß die Oberseite Wärme im wesentlichen durch Wärmeleitung in dem Gas an die Umgebung abgibt, und
- daß die Wärmezu- und ableit-Bedingungen zum bzw. vom Hohlkörper derart eingestellt sind, daß sich die Unterseite ohne Zufuhr eines Temperiermediums von außen auf eine wählbare Temperatur, durch die die CVD-Medien temperiert werden, einstellt, und daß zwischen der Oberseite und der Unterseite des Hohlkörpers ein positiver Temperaturgradient besteht.

2. Reaktor nach Anspruch 1,
**dadurch gekennzeichnet, daß** der Abstand zwischen Susceptor (Waferträger) und Hohlkörper zur Einstellung der Temperatur der Unterseite des Hohlkörpers einstellbar ist.

3. Reaktor nach Anspruch 2,
**dadurch gekennzeichnet, daß** zur Abstandseinstellung eine Halteeinheit für den Hohlkörper mit einem Gewinde vorgesehen ist.

4. Reaktor nach einem der Ansprüche 1 bis 3,
**dadurch gekennzeichnet, daß** der Reaktordeckel thermostatisiert ist.

5. Reaktor nach Anspruch 4,
**dadurch gekennzeichnet, daß** der Reaktordeckel eine Kühlung mittels eines flüssigen Mediums, wie Wasser aufweist.

6. Reaktor nach einem der Ansprüche 1 bis 5,
**dadurch gekennzeichnet, daß** zwischen Reaktordeckel und der Oberseite des Hohlkörpers ein Wärmeschild (Ceiling) vorgesehen ist.

7. Reaktor nach Anspruch 6,
**dadurch gekennzeichnet, daß** der Wärmeschild eine Platte aus einem wärmeresistenten und inerten Material, wie Quarz ist.

8. Reaktor nach Anspruch 6 oder 7,
**dadurch gekennzeichnet, daß** die Spülgaseinlaßvorrichtung einen ersten Gasauslaß in dem Zwischenraum zwischen Reaktordeckel und Wärmeschild und einen zweiten Gasauslaß in dem Zwischenraum zwischen Wärmeschild und Oberseite des Hohlkörpers aufweist.

9. Reaktor nach einem der Ansprüche 1 bis 8,
**dadurch gekennzeichnet, daß** die Spülgaseinlaßvorrichtung derart ausgebildet ist, daß die Zusammensetzung und/oder der Durchsatz des bzw. der in den bzw. die Zwischenräume oberhalb der Oberseite des Hohlkörpers eingeleiteten Gase zur Einstellung der Wärmeableitbedingungen änderbar ist.

10. Reaktor nach Anspruch 9,
**dadurch gekennzeichnet, daß** die Spülgaseinlaßvorrichtung unterschiedliche Gase bzw. Gaszusammensetzungen zwischen der Oberseite des Hohlkörpers und dem Wärmeschild und dem Wärmeschild und dem Reaktordeckel einleitet.

11. Reaktor nach Anspruch 9 oder 10,
**dadurch gekennzeichnet, daß** die Spülgaseinlaßvorrichtung ein Gasgemisch aus Gasen mit unterschiedlichen Wärmeleitung, wie z.B. aus H₂ und N₂ einleitet.

12. Reaktor nach einem der Ansprüche 1 bis 11,
**dadurch gekennzeichnet, daß** der Hohlkörper aus einem Metall mit guter Wärmeleitfähigkeit oder aus mehreren Lagen verschiedener Metalle mit unterschiedlichen Wärmeleitfähigkeiten, Reflexions-und Absorptionseigenschaften besteht.

13. Reaktor nach Anspruch 12,
**dadurch gekennzeichnet, daß** der Hohlkörper eine geringe Wärmekapazität hat.

14. Reaktor nach Anspruch 12 oder 13,
**dadurch gekennzeichnet, daß** der Hohlkörper eine dünne Scheibe ist.

15. Reaktor nach einem der Ansprüche 1 bis 14,
**dadurch gekennzeichnet, daß** der Susceptor (Waferträger) ein Planetensusceptor (Planetenwaferträger)mit doppelter Rotation ist.

16. Reaktor nach einem der Ansprüche 1 bis 14,
**dadurch gekennzeichnet, daß** der Susceptor (Waferträger) eine Scheibe ist.

17. Reaktor nach Anspruch 16,
**dadurch gekennzeichnet, daß** die Scheibe mechanisch oder auf Gas-Foil-Rotation rotiert.

18. Reaktor nach einem der Ansprüche 1 bis 17,
**dadurch gekennzeichnet, daß** der Hohlkörper oder Teile des Hohlkörpers drehbar ausgebildet ist, und die Scheibe und/oder der Suszeptor nicht gedreht wird.

19. Reaktor nach einem der Ansprüche 1 bis 18,
**dadurch gekennzeichnet, daß** die Fluideinlaßeinheit derart ausgebildet ist, daß Gase und/oder Flüssigkeiten, wie insbesondere Metall-organischen Lösungen im Hohlkörper gemischt werden können.

20. Reaktor nach einem der Ansprüche 1 bis 18,
**dadurch gekennzeichnet, daß** die Fluideinlaßeinheit derart ausgebildet ist, daß sie getrennte Öffnungen für unterschiedliche Fluide aufweist.

21. Reaktor nach Anspruch 20,
**dadurch gekennzeichnet, daß** die jeweiligen Öffnungen derart angeordnet sind, daß die Fluide nach ihrem Austritt aus den Öffnungen vermischt werden.

22. Reaktor nach einem der Ansprüche 1 bis 21,
**dadurch gekennzeichnet, daß** eine zusätzliche Temperiereinrichtung vorgesehen ist, die die Fluide vor ihrem Eintritt in den Hohlkörper (vor-)erwärmt.

23. Reaktor nach einem der Ansprüche 1 bis 22,
**dadurch gekennzeichnet, daß** die Fluideinlaßeinheit derart ausgebildet ist, daß sie gegenüber einem Ätz- bzw. Reinigungsgas resistent ist.

24. Reaktor nach einem der Ansprüche 1 bis 23,
**dadurch gekennzeichnet, daß** der Reaktor eine kreiszylindrische Form hat.

25. Reaktor nach einem der Ansprüche 1 bis 24,
**dadurch gekennzeichnet, daß** auch die Seitenwände des Reaktors thermostatisiert sind.

26. Reaktor nach einem der Ansprüche 1 bis 25,
**dadurch gekennzeichnet, daß** der Druck im Inneren des Reaktors zwischen ca. 0,1 und 1000 mbar beträgt.

27. Reaktor nach einem der Ansprüche 1 bis 26,
**dadurch gekennzeichnet, daß** die Fluideinlaßeinheit die CVD-Medien mit Drücken zwischen 0,1 und 10 bar einläßt.

28. Reaktor nach einem der Ansprüche 1 bis 27,
**dadurch gekennzeichnet, daß** eine Infrarot-Heizung, eine Widerstandsheizung oder eine Hochfrequenzheizung den Susceptor (Waferträger) beheizt.

29. Reaktor nach Anspruch 28,
**dadurch gekennzeichnet, daß** die Heizung den Susceptor (Waferträger) auf eine Temperatur zwischen ca. Raumtemperatur und 1200°C aufheizt.

30. Reaktor nach einem der Ansprüche 1 bis 29,
**dadurch gekennzeichnet, daß** zusätzlich zu dem Wärmeschild zwischen Oberseite des Hohlkörpers und Reaktordeckel weitere Wärmeschilde vorgesehen sind.

31. Verwendung der Vorrichtung nach einem der Ansprüche 1 bis 30 zur Herstellung dünner Schichten aus III-V, II-VI, IV-IV Materialien, ferner von ein- und mehrkomponentigen Oxyden, Perowskiten, insbesondere Barium- und Strontium-Titanat (ST bzw. BT), Barium-Strontium-Titanat (BST), Strontium- und Barium-Zirkonat-Titanate (BZT), Strontium-Wismut-Tantalat (SBT), Blei-Zirkonat-Titanat (PZT).

32. Verwendung nach Anspruch 31 zur Herstellung dünner dotierter und insbesondere Akzeptor- oder Donator-dotierter Schichten.

## Claims

1. CVD reactor comprising
- a reactor housing with a housing cover,
- a heated susceptor (wafer support) for one or several wafers, disposed in said reactor housing,
- a fluid inlet unit including a plurality of openings turned towards the wafer or wafers, through which the CVD media etc., which are heated to a moderate temperature in particular, enter the reactor, and
- a fluid outlet provided on the periphery of said reactor housing, through which the supplied media are discharged again,
**characterised in that**:
- that said fluid inlet unit comprises a hollow body spaced from said reactor cover, whose underside, in which the openings are provided, is substantially heated by heat radiated from said susceptor (wafer support) or by heat conduction therefrom,
- that a scavenging gas means is provided that introduces a scavenging gas into the space between the upper side of said hollow body and said reactor cover in such a way that the upper side will dissipate heat to the environment substantially by thermal conduction in the gas, and
- that the conditions of heat supply and heat dissipation to or from said hollow body are so set that the underside will adjust itself to a selectable temperature for heating the CVD media without supply of a temperature-moderating medium from the outside, and that a there is a positive temperature gradient between the upper side and the underside of said hollow body.

2. Reactor according to Claim 1,
**characterised in that** the spacing between said susceptor (wafer support) and said hollow body is adjustable for setting the temperature of the underside of said hollow body.

3. Reactor according to Claim 2,
**characterised in that** a holding unit with a thread is provided for holding said hollow body for adjustment of the spacing.

4. Reactor according to any of the Claims 1 to 3,
**characterised in that** said reactor cover is thermostatically temperature-controlled.

5. Reactor according to Claim 4,
**characterised in that** said reactor cover comprises cooling means operating on a liquid medium such as water.

6. Reactor according to any of the Claims 1 to 5,
**characterised in that** a thermal shield (ceiling) is provided between said reactor cover and the upper side of said hollow body.

7. Reactor according to Claim 6,
**characterised in that** said thermal shield is a plate of a heat-resistant and inert material such as quartz.

8. Reactor according to Claim 6 or 7,
**characterised in that** said scavenging gas inlet means comprises a first gas outlet in the space between said reactor cover and said thermal shield and a second gas outlet in the space between said thermal shield and the upper side of said hollow body.

9. Reactor according to any of the Claims 1 to 8,
**characterised in that** said scavenging gas means is so configured that the composition and/or the flow rate of the gas or gases introduced into the space or spaces above the upper side of said hollow body is variable for adjusting the conditions of heat dissipation.

10. Reactor according to Claim 9,
**characterised in that** said scavenging gas inlet means supplies different gases or gas compositions into the space between the upper side of said hollow body and said thermal shield and into the space between said thermal shield and said reactor cover.

11. Reactor according to Claim 9 or 10,
**characterised in that** said scavenging gas inlet means supplies a gas mixture consisting of gases having a different thermal conduction coefficient, e.g. of H₂ and N₂.

12. Reactor according to any of the Claims 1 to 11,
**characterised in that** said hollow body consists of a metal displaying a good thermal conduction or of several layers of different metals of different thermal conduction coefficients, reflection properties and absorption characteristics.

13. Reactor according to Claim 12,
**characterised in that** said hollow body has a low thermal capacity.

14. Reactor according to Claim 12 or 13,
**characterised in that** said hollow body is a thin disk.

15. Reactor according to any of the Claims 1 to 14,
**characterised in that** said susceptor (wafer support) is a planetary susceptor (planetary wafer support) with dual rotation.

16. Reactor according to any of the Claims 1 to 14,
**characterised in that** said susceptor (wafer support) is a disk.

17. Reactor according to Claim 16,
**characterised in that** said disk rotates mechanically or by gas foil rotation.

18. Reactor according to any of the Claims 1 to 17,
**characterised in that** said hollow body or parts of said hollow body are designed for rotation and that said disk and/or said susceptor is not rotated.

19. Reactor according to any of the Claims 1 to 18,
**characterised in that** said fluid inlet unit is so designed that gases and/or liquids such as metallo-organic solutions in particular may be mixed in said hollow body.

20. Reactor according to any of the Claims 1 to 18,
**characterised in that** said fluid inlet unit is so designed that it presents separate openings for different fluids.

21. Reactor according to Claim 20,
**characterised in that** the respective openings are so arranged that the fluids will be mixed after their discharge from said openings.

22. Reactor according to any of the Claims 1 to 21,
**characterised in that** additional means for heating to a moderate temperature are provided which (pre-)heat the fluids prior to their entry into said hollow body.

23. Reactor according to any of the Claims 1 to 22,
**characterised in that** said fluid inlet means is so designed that it will be resistant to an etching or cleaning gas.

24. Reactor according to any of the Claims 1 to 23,
**characterised in that** the reactor has a circular cylindrical shape.

25. Reactor according to any of the Claims 1 to 24,
**characterised in that** the side walls of the reactor are equally thermostatically temperature-controlled.

26. Reactor according to any of the Claims 1 to 25,
**characterised in that** the pressure inside the reactor amounts to 0.1 to 1,000 mbar approximately.

27. Reactor according to any of the Claims 1 to 26,
**characterised in that** said fluid inlet unit supplies the CVD media at pressures between 0.1 and 10 bar.

28. Reactor according to any of the Claims 1 to 27,
**characterised in that** an infrared heating, a resistance heating or a high-frequency heating heats said susceptor (wafer support).

29. Reactor according to Claim 28,
**characterised in that** said heating heats said susceptor (wafer support) to a temperature approximately between the room temperature and 1,200 °C.

30. Reactor according to any of the Claims 1 to 29,
**characterised in that** further thermal shields are provided, in addition to said thermal shield, between the upper side of said hollow body and said reactor cover.

31. Application of the device according to any of the Claims 1 to 30 for the production of thin layers of II-V, II-VI, IV-IV materials, moreover of single-component and multiple-component oxides, perovskites, in particular barium and strontium titanate (ST or BT, respectively), barium-strontium titanate (BST), strontium and barium zirconate titanates, strontium-bismuth tantalate (SBT), lead-zirconate titanate (PZT).

32. Application according to Claim 31 for the production of thin doped layers and particularly layers with acceptor and/or donator materials.

## Revendications

1. Réacteur DCP comprenant
- une enveloppe de réacteur à un couvercle d'enveloppe,
- un support de galette (susceptor) chauffé pour une ou plusieurs galette(s), qui est disposé dans ladite enveloppe de réacteur,
- une unité d'entrée de fluide comprenant une pluralité d'orifices tournés vers la ou les galette(s), par lesquelles les milieux DCP etc., qui sont tempérés en particulier, entrent dans le réacteur, et
- un moyen de sortie de fluide disposé sur la périphérie de ladite enveloppe de réacteur, par lequel les milieux alimentés sont fait sortir,
**caractérisé** en ce :
- que ladite unité d'entrée de fluide comprend un corps creux écarté dudit couvercle de réacteur, dont la face inférieure, dans laquelle lesdits orifices sont formés, est essentiellement chauffée par la chaleur rayonnée dudit support de galette (susceptor) ou par conduction de chaleur,
- qu'un moyen de gaz laveur est disposé, qui introduit du gaz laveur dans l'espace entre la face supérieure dudit corps creux et ledit couvercle de réacteur de façon que la face supérieure dissipe de chaleur dans les environs essentiellement par conduction de chaleur dans le gaz, et
- en ce que les conditions d'amenée et de dissipation de chaleur vers ledit ou dudit corps creux sont réglées de façon que la face inférieure s'adapte soi-même à une température choisissable afin de chauffer les milieux DCP sans alimentation d'un milieu tempérant de l'extérieur, et qu'il y ait un gradient de température positif entre la face supérieure et la face inférieure dudit corps creux.

2. Réacteur selon la revendication 1,
**caractérisé en ce que** l'écart entre ledit support de galette (susceptor) et ledit corps creux est réglable afin de régler la température de la face inférieure dudit corps creux.

3. Réacteur selon la revendication 2,
**caractérisé en ce qu'**une unité de soutien à filetage est disposée afinde soutenir ledit corps creux pour le réglage de l'écart.

4. Réacteur selon une quelconque des revendications 1 à 3,
**caractérisé en ce que** la température dudit couvercle de réacteur est réglé de façon thermostatique.

5. Réacteur selon la revendication 4,
**caractérisé en ce que** ledit couvercle de réacteur comprend des moyens de refroidissement, qui fonctionnent à la base d'un milieu liquide comme de l'eau.

6. Réacteur selon une quelconque des revendications 1 à 5,
**caractérisé en ce qu'**un écran calorifuge (ceiling) est monté entre ledit couvercle de réacteur et la face supérieure dudit corps creux.

7. Réacteur selon la revendication 6,
**caractérisé en ce que** ledit écran calorifuge est une plaque en un matériau résistant à la chaleur et inerte, comme le quartz.

8. Réacteur selon la revendication 6 or 7,
**caractérisé en ce que** ledit moyen d'entrée de gaz laveur comprend un premier orifice de sortie de gaz dans l'espace entre ledit couvercle de réacteur et ledit écran calorifuge, ainsi qu'un deuxième orifice de sortie de gaz dans l'espace entre ledit écran calorifuge et la face supérieure dudit corps creux.

9. Réacteur selon une quelconque des revendications 1 à 8,
**caractérisé en ce que** ledit moyen de gaz laveur est configuré de façon que la composition et/ou le débit du ou des gaz introduit(s) dans l'espace ou les espaces au-dessus de la face supérieure dudit corps creux soient variables afin de régler les conditions de dissipation de chaleur.

10. Réacteur selon la revendication 9,
**caractérisé en ce que** ledit moyen d'entrée de gaz laveur amène des gaz ou des compositions de gaz différents dans l'espace entre la face supérieure dudit corps creux et ledit écran calorifuge et dans l'espace entre ledit écran calorifuge et ledit couvercle de réacteur.

11. Réacteur selon la revendication 9 or 10,
**caractérisé en ce que** ledit moyen d'entrée de gaz laveur amène un mélange de gaz composé des gaz aux coefficients différents de conduction de chaleur, par exemple de H₂ et N₂.

12. Réacteur selon une quelconque des revendications 1 à 11,
**caractérisé en ce que** ledit corps creux est fait en un métal à bonne conduction de chaleur ou en plusieurs couches de métaux à coefficients différents de conduction de chaleur et aux caractéristiques différentes de réflexion et d'absorption.

13. Réacteur selon la revendication 12,
**caractérisé en ce que** ledit corps creux a une petite capacité thermique.

14. Réacteur selon la revendication 12 or 13,
**caractérisé en ce que** ledit corps creux est un disque mince.

15. Réacteur selon une quelconque des revendications 1 à 14,
**caractérisé en ce que** ledit support de galette (susceptor) est un support de galette planétaire (planetary wafer support) à double rotation.

16. Réacteur selon une quelconque des revendications 1 à 14,
**caractérisé en ce que** ledit support de galette (susceptor) est un disque.

17. Réacteur selon la revendication 16,
**caractérisé en ce que** ledit disque tourne de façon mécanique ou par rotation sur un coussin de gaz.

18. Réacteur selon une quelconque des revendications 1 à 17,
**caractérisé en ce que** ledit corps creux ou parties dudit corps creux sont conçus pour une rotation, et **en ce que** ledit disque et/ou ledit support ne tourne pas.

19. Réacteur selon une quelconque des revendications 1 à 18,
**caractérisé en ce que** ladite unité d'entrée de fluide est conçue de façon qu'on puisse mélanger des gaz et/ou des liquides, par exemple des solutions métallo-organiques en particulier, dans ledit corps creux.

20. Réacteur selon une quelconque des revendications 1 à 18,
**caractérisé en ce que** ladite unité d'entrée de fluide est conçue de façon qu'elle présente des orifices séparés pour des fluides différents.

21. Réacteur selon la revendication 20,
**caractérisé en ce que** les orifices respectifs sont disposés de manière que les fluides soient mélangés après leur sortie desdites orifices.

22. Réacteur selon une quelconque des revendications 1 à 21,
**caractérisé en ce que** des moyens supplémentaires à tempérer sont prévus, qui (pré-)chauffent des fluides avant leur entrée dans ledit corps creux.

23. Réacteur selon une quelconque des revendications 1 à 22,
**caractérisé en ce que** ledit moyen d'entrée de fluide est conçu de façon qu'il soit résistant à un gaz caustique ou de dépollution.

24. Réacteur selon une quelconque des revendications 1 à 23,
**caractérisé en ce que** le réacteur a la forme d'un cylindre circulaire.

25. Réacteur selon une quelconque des revendications 1 à 24,
**caractérisé en ce que** la température des parois latérales du réacteur est également réglée de façon thermostatique.

26. Réacteur selon une quelconque des revendications 1 à 25,
**caractérisé en ce que** la pression à l'intérieur du réacteur correspond à 0.1 à 1,000 mbar environ.

27. Réacteur selon une quelconque des revendications 1 à 26,
**caractérisé en ce que** ladite unité d'entrée de fluide amène les milieux DCP aux pressions entre 0.1 et 10 bars.

28. Réacteur selon une quelconque des revendications 1 à 27,
**caractérisé en ce qu'**un moyen de chauffage aux rayons infrarouges, de chauffage ohmique ou de chauffage à haute fréquence chauffe ledit support de galette (susceptor).

29. Réacteur selon la revendication 28,
**caractérisé en ce que** ledit moyen de chauffage chauffe ledit support de galette (susceptor) à une température environ entre la température ambiante et 1,200 °C.

30. Réacteur selon une quelconque des revendications 1 à 29,
**caractérisé en ce que** des écrans calorifuges supplémentaires sont disposés, au plus dudit écran calorifuge, entre la face supérieure dudit corps creux et ledit couvercle de réacteur.

31. Application du dispositif selon une quelconque des revendications 1 à 30 pour la production de couches minces en matériaux II-V, II-VI, IV-IV, de plus en oxydes à un seul composant ou aux composants multiples, en perovskites, en particulier le titanate de baryum et strontium titanate (ST ou respectivement BT), titanate de baryum-strontium (BST), des titanates de strontium et de zirconate de baryum, tantalate de strontium-bismuth tantalate (SBT), titanate de plomb-zirconate titanate (PZT).

32. Application selon la revendication 31 pour la fabrication de couches minces dopées et en particulier des couches aux matériaux accepteur et/ou donneur.
